# EUROPÄISCHE PATENTSCHRIFT

(11) **EP 1 959 158 B1**
(45) Veröffentlichungstag und Bekanntmachung des Hinweises auf die Patenterteilung: **02.08.2017**
(21) Anmeldenummer: 08002729.5
(22) Anmeldetag: 14.02.2008
(51) Int. Cl.: F16F 15/02, G03F 7/20, G10K 11/175

(54) **Verfahren zur Anpassung eines Schwingungsisolationssystems**
Method for customising an oscillation isolation system
Procédé destiné à l'adaptation d'un système d'isolation des vibrations

(30) Priorität: 14.02.2007 DE 102007007911
(43) Veröffentlichungstag der Anmeldung: 20.08.2008
(73) Patentinhaber: Integrated Dynamics Engineering GmbH, 65479 Raunheim (DE)
(72) Erfinder: Heiland, Peter, 65479 Raunheim (DE)
(74) Vertreter: Herden, Andreas F.

(56) Entgegenhaltungen:
- JP-A- 2001 023 881
- US-A- 5 508 518
- US-A- 5 917 919
- US-A- 6 002 987
- US-A1- 2003 029 670
- US-A1- 2003 058 417
- US-B1- 6 450 288
- US-B1- 6 477 908

## Beschreibung

Die Erfindung betrifft ein Schwingungsisolationssystem.

Schwingungsisolationssysteme sind bekannt. So zeigt beispielsweise die DE 698 17 750 T2 (Erfinder Erik Loopstra, Peter Heiland) ein Schwingungsisolationssystem, welches zur Aufnahme eines Lithographiegerätes ausgebildet ist. Dabei wird die zu lagernde Last, welche typischerweise einen Tisch und darauf gelagerte Bauelemente wie Fertigungsanlagen umfasst, auf Luftlagern gelagert.

Zur Verbesserung der Schwingungsisolation weisen sogenannte aktive Schwingungsisolationssysteme Sensoren und Aktoren auf, mittels denen eine gezielte Gegensteuerung möglich ist. Dabei erfassen die Sensoren Bewegungen der zu lagernden Last. Über eine Regeleinrichtung werden Aktoren des Schwingungsisolationssystems angesteuert und wirken Schwingungen, welche sowohl von außen auf das System einwirken können, als auch durch die zu lagernde Last generiert werden können, entgegen.

Insbesondere in der Halbleiterindustrie werden mit zunehmender Miniaturisierung der Bauteile die Anforderungen an derartige Schwingungsisolationssysteme immer höher.

Dabei handelt sich insbesondere um niederfrequent abgestimmte (<1Hz) Schwingungsisolationssysteme für den Einsatz in der Lithographie, bei Steppern, Immersionssystemen u.ä., insbesondere auch solche, die eine sehr kleine horizontale Steifigkeit aufweisen.

Nach aus der Praxis bekannten Verfahren zur Konstruktion von Schwingungsisolationssystem werden die Eigenschaften des Systems unabhängig von den äußeren Gegebenheiten charakterisiert, in dem auf festgelegten mechanischen Szenarien bestimmte Systemparameter und -eigenschaften vermessen werden. Die für ein Schwingungsisolationssystem wichtigste Eigenschaft ist die Isolation, also die Übertragungsfunktion zwischen Bodenschwingung und Massenschwingung.

Es sind aber auch Auswirkungen von Schallwellen auf Material bekannt (Casimir-Effekt, siehe "An acoustic Casimir effect, Andres Larraza und Bruce Denardo, Phys. Lett. A 348, 151-155 (1998)), die für Schwingungsisolationssysteme Bedeutung haben.

Diese Auswirkungen werden bei bekannten Schwingungsisolationssystem bzw. bei Verfahren zur Konstruktion von Schwingungsisolationssystem nicht oder nicht ausreichend berücksichtigt.

Die Offenlegungsschrift US 2003/0029670 A1 zeigt einen Träger zur akustischen Insolation insbesondere von Lautsprechern.

### Aufgabe der Erfindung:

Der Erfindung liegt demgegenüber die Aufgabe zugrunde, ein Schwingungssisolationsystem bereit zu stellen, bei welchem die Isolationswirkung verbessert wird.

### Zusammenfassung der Ereindung:

Die Aufgabe der Erfindung wird durch ein Schwingungsisolationssystem nach Anspruch 1 erreicht.

Gemäß einem nicht erfindungswesentlichen Verfahren zur Anpassung des erfindungsgemäßen Schwingungsisolationssystems kann die Umgebung, in die das Schwingungsisolationssystem eingebracht ist oder eingebracht wird, ermittelt werden. Dabei werden insbesondere Form, Material, Masse und/oder Entfernung von das Schwingungsisolationssystem umgebenden Körpern, wie Wänden, Böden oder Schallquellen bestimmt.

Auf Basis dieser ermittelten Randbedingungen können konstruktive Maßnahmen für die Umgebung zur Reduzierung von Umgebungseinflüssen ermittelt und durchgeführt werden. Es wird also die Umgebung bei der Auslegung des Schwingungsisolationssystems berücksichtigt.

Insbesondere ist vorgesehen, das Schwingungsisolationssystem umgebende Körper, insbesondere Wände, zumindest abschnittsweise mit schallisolierendem Material zu versehen. So können Resonanzeffekte, die das Schwingungsisolationssystem in seiner Wirkung beeinträchtigen, verringert werden.

Dabei werden Resonanzvolumina, welche insbesondere in Folge planparalleler Flächen entstehen, erfasst und geeignete Maßnahmen wie etwa Strukturieren von Wänden oder Aufbringen von schallisolierten Material durchgeführt, um die Resonanzvolumina zu beseitigen.

Es hat sich gezeigt, dass in vielen Fällen bereits das bloße Aufbringen einer Struktur, beispielsweise einer wabenförmigen Struktur ausreicht, um Resonanzeffekte im Raum auf ein Maß zu reduzieren, welches zu keiner nennenswerten Beeinträchtigung des Schwingungsisolationssytems führt.

Es hat sich gezeigt, dass ein Resonanzvolumen, welches sich zwischen der Unterseite eines schwingungsisoliert gelagerten Tisches und dem Boden bildet, störende Effekte verursacht. Ein derartiges Resonanzvolumen wird gemäß der Erfindung auf besonders einfache Weise durch Strukturieren der schwingungsisoliert zu lagernden Platte beseitigt werden.

Weiter kann vorgesehen sein, zumindest ein Bauteil des Schwingungsisolationssystem zur Reduktion des Strömungswiderstandes mit einer strukturierten Oberfläche zu versehen. So können insbesondere durch Luftbewegungen, beispielsweise von einer Klimatisierung verursachte Störungen reduziert werden.

Weiter kann zur Reduzierung von Störungen durch Schall vorgesehen sein, dass in der Umgebung des Schwingungsisolationssystems zumindest ein Lautsprecher angeordnet ist, der eine aktive Regelung aufweist. Vorzugsweise ist die aktive Regelung mit zumindest einem Vibrationsaufnehmer, der Schwingungen einer zu isolierenden Last erfasst, verbunden. Schallwellen in Folge von Schwingungen des Systems können so über die aktive Regelung der Lautsprecher reduziert werden.

Zusätzlich oder alternativ kann die aktive Regelung auch zur Reduzierung von Umgebungsgeräuschen ausgebildet sein.

Gemäß der Erfindung wird die Anzahl planparalleler Flächen, welche Resonanzeffekte verursachen können, durch Abrundungen und/oder Öffnungen in der Basisplatte des Schwingungsisolationssystems reduziert.

Es kann gemessen werden, dass das Verhalten von Schwingungsisolationssystemen abhängig von der umgebenden Geometrie ist. Insbesondere die Isolationswirkung kann beeinträchtigt werden, wenn ungünstige Faktoren "außerhalb" liegender Bauteile oder Gegenstände vorliegen.

Es hat sich also herausgestellt, dass ein Schwingungsisolationssystem nicht ausschließlich durch systemimmanente Faktoren charakterisiert ist. Vielmehr kommt es auch darauf an, wie sich die bewegenden Massen und Flächen gegeneinander verhalten. Ein System in der Nähe einer Wand wird sich anders verhalten als eines in einem großen Raum. Aber auch die Anordnung von Flächen des Schwingungsisolationssystems an sich, relativ zu feststehenden Flächen kann bei geräuschvoller Umgebung (Halbleiter-Fertigungsfabriken) Kräfte induzieren (Casimir-Effekt).

Bei Bewegungen eines Systems wird der Luftraum zwischen Basismasse und Boden größer und kleiner, je nachdem wie und mit welcher Frequenz sich das System bewegt. Sind Basismasse und Boden planparallel, so bleibt der Luft nur der Weg zum Rand der Masse nach Außen. Die Ausbildung der Basismassen-Unterseite hat entscheidenden Einfluss auf die Strömungsrichtung und -stärke. Dabei sollte man besser von Schnelleschwankungen oder Druckschwankungen und der Analogie der Akustik bleiben. Allerdings drängt sich wegen der niedrigen Frequenzen (<300Hz) das Bild der Strömung auf.

Im üblichen Fall von planparallelen Flächen (Basismasse und Boden) sind also die Beschaffenheit der Flächen, sowie deren Abstand voneinander, als auch die Ränder von Bedeutung. In Analogie eines Helmholtz-Resonators in der Akustik (bei der Luft in einem Flaschenhals schwingt und das Volumen der Flasche als Steifigkeit wirkt), können hier die Reibungsverluste an den Flächen, sowie die beteiligten Volumina (an den Austrittsflächen und im Inneren) zu einer zusätzlichen Steifigkeit führen, die die Isolationseigenschaften des Systems deutlich beeinflussen. Es kann dabei zu deutlichen resonanzartigen Effekten kommen, die die Isolationswirkung mindestens schmalbandig zerstören bzw. deutlich herabsetzen. Ist der Abstand der Flächen groß gegen die Fläche selbst, tritt dieser Effekt in den Hintergrund. Mit Hilfe von konstruktiven Mitteln in der Basismasse, lässt sich dieser Effekt verhindern. Zusätzliche Öffnungen in der Mitte oder Herabsenken des Strömungswiderstands der Oberflächen minimieren den Einfluss dieses Effekts.

In anderen Fällen ist der Aufbau der zu isolierenden Masse selbst Quelle von Luftverschiebungen. Da diese Masse recht voluminös sein kann, sind die mit ihrer Bewegung bewegten Luftmassen ebenfalls nicht klein. Daher gewinnen die konstruktiven Formen in der Umgebung des Systems (und der bewegten Masse) an Bedeutung, da sie die Luftströmungen behindern können.

Es lässt sich dieser wie auch obiger Effekt auch über den Strahlungswiderstand argumentieren. Stellt man sich die planparallelen Platten bzw. die Masse des Systems (den Aufbau) als Quelle von akustischer Abstrahlung vor, so sieht diese eine Strahlungsimpedanz. Diese beeinflusst die Quelle, so dass diese in ihrer Bewegung beeinträchtigt werden kann. Es kann daher mit Hilfe dieser Argumentation gezeigt werden, dass durch konstruktive Auslegung der Umgebung Einfluss auf das Verhalten des Systems genommen werden kann.

So kann z.B.
a) die umgebenden Wände mit akustisch wirksamem Schalldämmstoff ausgeführt werden, so dass der Strahlungswiderstand dem des Freifeldes gleichkommt
b) die umgebenden Wände gezielt so geformt werden, dass der Strömungswiderstand minimiert wird, z.B. durch gekrümmte Flächenteile mit niedrigem cw-Wert
c) mittels Lautsprecheranordnungen dafür gesorgt werden, dass die Luftströmungen mittels aktiver bewegter Membranfläche unterstützt oder unterbunden wird. Eine solche aktive Impedanzanpassung wird beispielsweise in folgenden Literaturstellen beschrieben, auf deren Offenbarungsgehalt hiermit vollumfänglich Bezug genommen wird:
   D. Guicking and M. Wenzel: Adaptive Filter Concept for Active Control of Acoustic Wall Impedance. ASME Paper 86-WA/NCA-28, Dec. 1986 (3 p.)
   M. Wenzel und D. Guicking: Konzept zur aktiven Reflexionsfaktorregelung mit adaptiven Digitalfiltern. In: Fortschritte der Akustik, DAGA '87 (Aachen). DPG-GmbH, Bad Honnef 1987, S. 505-508

Weiter kann die Minimierung des Casimir-Effekts durch konstruktive Änderungen möglicher Flächen gegeneinander, um die gerichtete Induktion von Kräften zu minimieren, betreffen.

Bei der Qualifikation und bei der Auslegung von Schwingungsisolationssystemen wird die Umgebung mit einbezogen. Nicht erfindungsgemäße konstruktive Maßnahmen um ein bestehendes Isolationssystem herum (oder in dessen unmittelbarer Nähe), welches dazu führt, die Rückwirkungen auf dieses zu minimieren, in dem
1. Schalldämmungsmaßnahmen an den umgebenden Wänden ausgeführt werden
2. die Formgebung der Wände und Wandelemente eine Umströmung von Luft begünstigen
3. durch aktive Methoden (z.B. Lautsprecher) aktiv Einfluss auf die akustische Impedanz der Umgebung genommen wird.

Weiter können konstruktive Maßnahmen vorgesehen sein, um bei geräuschvollen Umgebungen die Kraftinduktion zu vermindern (Casimir-Effekt), indem planparallele Flächen mit der Umgebung minimiert werden.

Diese können insbesondere sein:
1) Schallschluck-Anordnungen mit porösen, strömungswiderstandsbehafteten, tieffrequent wirksamen Schluckstoffen an den Wänden der Umgebung
2) Beschichtete Wandflächen, die die Umströmung begünstigen und einen niedrigen cw-Wert haben
3) Lautsprecher-Anordnungen an den Wänden, die durch eine Regelung das Strömungsverhalten beeinflussen kann.

### Beschreibung der Zeichnungen:

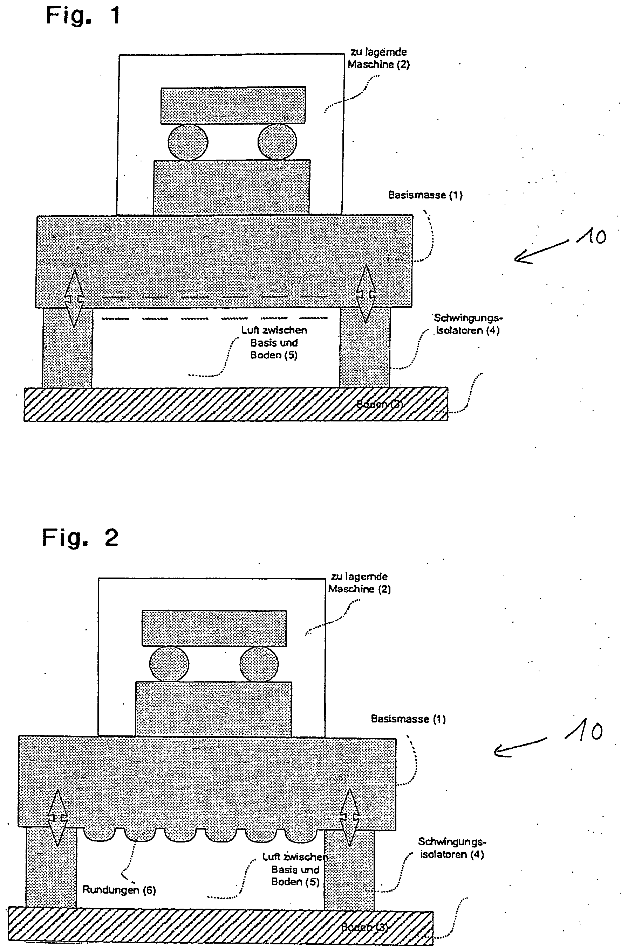

Die Erfindung soll anhand der Zeichnungen Fig. 1 bis Fig. 4 bezug nehmend auf schematisch dargestellte Ausführungsbeispiele näher erläutert werden.

Fig. 1 zeigt schematisch den Aufbau eines Schwingungsisolationsystems 10. Das Schwingungsisolationsystems 10 umfasst eine Basismasse 1, welche durch Schwingungsisolatoren 4 schwingungsisoliert auf dem Boden 3 gelagert ist. Auf der Basismasse 1 ist eine zu lagernde Maschine 2 angeordnet. Insbesondere aufgrund der planparallel zum Boden 3 ausgerichteten Basismasse 1 kann des zu Resonanzeffekten in der Luft 5 zwischen Basismasse 1 und Boden kommen.

Bei dem Schwingungsisolationssystem 10 gemäß Fig. 2 weist die Unterseite der Basismasse 1 Rundungen 6 auf, mit denen die planparallele Anordnung vermieden wird. Resonanzeffekte werden so weitgehend vermieden.

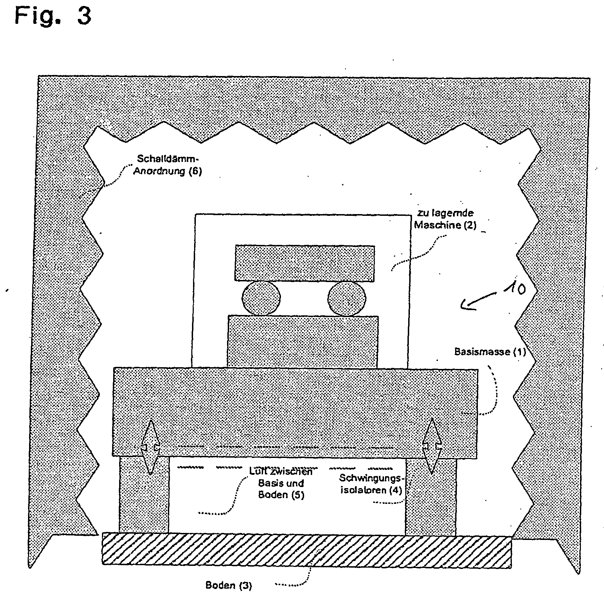

Bei dem Schwingungsisolationssystem 10 gemäß Fig. 3, aber nicht erfindungsgemäß, die Wände der Umgebung mit einer Schalldämmung 6 ausgekleidet.

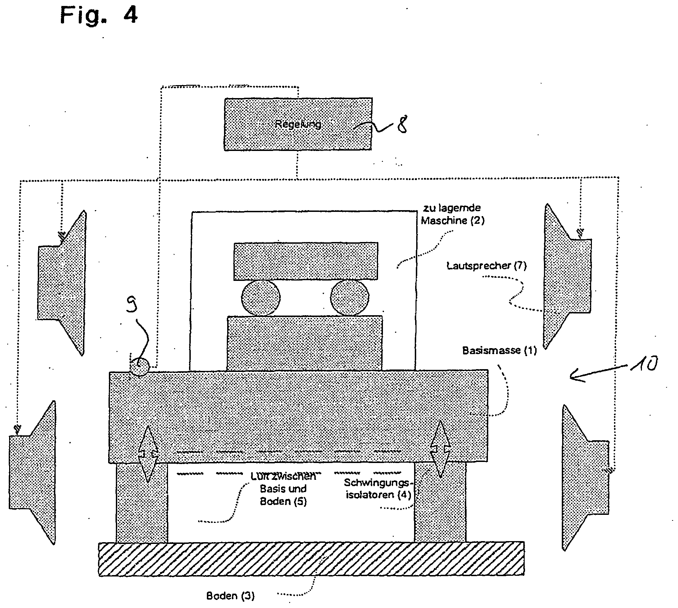

In Fig. 4 sind die Wände (nicht dargestellt) der Umgebung des (nicht erfindungsgemäßen) Schwingungsisolationssystems mit Lautsprechern versehen, die mit einer aktiven Regelung 8 verbunden sind. Die aktive Regelung 8 ist unter anderem mit einem Sensor 9 zur Erfassungen von Schwingungen der Basismasse verbunden.

Durch die aktive Regelung werden so auch durch Schwingungen der Basismasse verursachte Schallwellen reduziert. Auch störenden Reflexionen von Schallwellen an den Wänden kann so entgegengewirkt werden.

## Patentansprüche

1. Schwingungsisolationssystem, zur Aufnahme eines Halbleiter-Lithographiegerätes, welches auf einem Boden angeordnet ist, wobei das Schwingungsisolationssystem eine auf Schwingungsisolatoren schwingungsisoliert auf dem Boden gelagerte Basisplatte aufweist, auf welcher eine zu isolierende Baugruppe angeordnet ist, **dadurch gekennzeichnet, dass** die Basisplatte zumindest abschnittsweise Öffnungen und/oder Abrundungen auf der Unterseite, mit denen die Anzahl planparalleler Flächen, welche Resonanzeffekte verursachen können zwischen Boden und Basisplatte reduziert wird, aufweist.

2. Schwingungsisolationssystem nach dem vorstehenden Anspruch, **dadurch gekennzeichnet, dass** zumindest 50 % der Fläche der Unterseite der Basisplatte strukturiert ist.

## Claims

1. Vibration isolation system for supporting a semiconductor lithography device,
which is arranged on a floor, wherein the vibration isolation systems comprises a base plate being vibration isolated supported on the floor by vibration isolators, **characterized in that** the base plate comprises, at least in sections, roundings and/or openings on its bottom side, which reduce the number of plane-parallel surface areas, which may generate resonance effects between floor and base plate.

2. The vibration isolation system according to the preceding claims, wherein at least 50% of the surface area of the bottom side is structured.

## Revendications

1. Système d'isolation de vibrations destiné à recevoir un appareil de lithographie à semi-conducteurs, lequel est agencé sur un sol, le système d'isolation de vibrations comprenant une plaque de base montée sur le sol de manière à être isolée des vibrations par des isolateurs de vibrations, sur laquelle est agencé un ensemble à isoler, **caractérisé en ce que** la plaque de base comprend au moins sur certaines parties des ouvertures et/ou des arrondis sur la face inférieure, lesquels permettent de réduire le nombre de surfaces à faces planes et parallèles, lesquelles sont susceptibles de provoquer des effets de résonance, entre le sol et la plaque de base.

2. Système d'isolation de vibrations selon la revendication précédente, **caractérisé en ce qu'**au moins 50 % de la surface de la face inférieure de la plaque de base est structurée.
